# EUROPÄISCHE PATENTANMELDUNG

(11) **EP 2 708 913 A1**
(43) Veröffentlichungstag der Anmeldung: **19.03.2014**
(21) Anmeldenummer: 12184919.4
(22) Anmeldetag: 18.09.2012
(51) Int. Cl.: G01S 7/481, G01S 7/487, G01S 17/42, G01S 17/89, G01S 7/486, G01C 3/08, H01L 27/146, H01L 31/107

(54) **Optoelektronischer Sensor und Verfahren zur Objekterfassung**

(71) Anmelder: SICK AG, 79183 Waldkirch (DE)
(72) Erfinder: Hug, Gottfried, 79183 Waldkirch (DE); Tschuch, Dr. Sebastian, 79104 Freiburg (DE)
(74) Vertreter: Hehl, Ulrich

(57) **Zusammenfassung**

Es wird ein optoelektronischer Sensor (10) mit einem Lichtempfänger (28) angegeben, der eine Vielzahl von Lawinenphotodiodenelementen (30) zur Erfassung von Empfangslicht (24) aus einem Überwachungsbereich (20) aufweist, die jeweils mit einer Vorspannung oberhalb einer Durchbruchspannung vorgespannt und somit in einem Geiger-Modus betrieben sind. Der Sensor (10) umfasst mindestens eine Gruppenauswertungseinheit (36), die mit einer Gruppe (46) der Lawinenphotodiodenelemente (30) verbunden ist, um deren Empfangssignal zu empfangen, und die dafür ausgebildet ist, nur Ereignisse als Erfassung von Empfangslicht (24) zu werten, bei denen eine Mindestanzahl von Lawinenphotodiodenelementen (30) der Gruppe (46) innerhalb eines Toleranzzeitintervalls gleichzeitig ein Empfangssignal erzeugt.

## Beschreibung

Die Erfindung betrifft einen optoelektronischen Sensor mit einem Lichtempfänger, der eine Vielzahl von im Geiger-Modus betriebenen Lawinenphotodiodenelementen aufweist, sowie ein Verfahren zur Objekterfassung nach dem Oberbegriff von Anspruch 1 beziehungsweise 15.

Optoelektronische Sensoren gibt es in einem breiten Spektrum, das von eindimensionalen Lichtschranken und Lichttastern über Laserscanner bis zu Kameras reicht. Über die reine Objekterfassung hinaus wird in entfernungsmessenden Systemen auch eine Distanz zu dem Objekt bestimmt. Distanzsensoren nach dem Lichtlaufzeitprinzip messen dazu die Laufzeit eines Lichtsignals, die über die Lichtgeschwindigkeit der Entfernung entspricht. Man unterscheidet herkömmlich die pulsbasierte und die phasenbasierte Messung. In einem Pulslaufzeitverfahren wird ein kurzer Lichtpuls ausgesandt und die Zeit bis zum Empfang einer Remission oder Reflexion des Lichtpulses gemessen. Alternativ wird bei einem Phasenverfahren Sendelicht amplitudenmoduliert und eine Phasenverschiebung zwischen Sende- und Empfangslicht bestimmt, wobei die Phasenverschiebung ebenfalls ein Maß für die Lichtlaufzeit ist. Die Grenze zwischen den beiden Verfahren lässt sich aber nicht immer scharf ziehen, denn etwa bei komplexen Pulsmustern wird ein Pulslaufzeitverfahren einem Phasenverfahren ähnlicher als einer klassischen Einzelpulsmessung.

Mit Hilfe der Distanzinformation werden auch dreidimensionale Bilder oder sogenannte Tiefenkarten erfasst, wenn der Sensor ortsauflösend ist. Ein Scanner tastet dazu mit einem Lichtstrahl den Überwachungsbereich ab, während eine 3D-Kamera für jedes ihrer Pixel statt oder neben der Helligkeitsinformation auch eine Distanzinformation bestimmt. Dazu wird beispielsweise in jedem Pixel eine Lichtlaufzeitmessung implementiert.

In den meisten Fällen und besonders bei der Entfernungsmessung muss der Sensor zwischen Nutzlicht, beispielsweise eines eigenen oder zugeordneten Lichtsenders, und Umgebungslicht oder Störungen von anderen Lichtquellen unterscheiden können. Je nach Anwendung, etwa in besonders hellen Umgebungen, bei schlecht remittierenden Zielobjekten oder großen Messentfernungen, kann dies bei äußerst geringem Nutzlichtpegel eine sehr anspruchsvolle Aufgabe sein.

Um auch geringe Empfangsintensitäten nachweisen zu können, werden herkömmlich in manchen optoelektronischen Sensoren Lawinenphotodioden eingesetzt (APD, Avalanche Photo Diode). Das einfallende Licht löst hier einen kontrollierten Lawinendurchbruch (Avalanche Effect) aus. Dadurch werden die durch einfallende Photonen erzeugten Ladungsträger vervielfacht, und es entsteht ein Photostrom, der zu der Lichtempfangsintensität proportional, dabei aber wesentlich größer ist als bei einer einfachen PIN-Diode.

In der Arbeit von Aull et al., "Geiger-Mode Avalance Photodiodes for Three Dimensional Imaging", Lincoln Laboratory Journal 13(2), 2002, Seiten 335-350, wird die Verwendung von Lawinenphotodioden im sogenannten Geiger-Modus für Laserradar diskutiert. Im Geiger-Modus ist die Lawinenphotodiode oberhalb der Durchbruchspannung vorgespannt, so dass bereits ein einziger, durch ein einzelnes Photon freigesetzter Ladungsträger eine Lawine auslöst, die dann aufgrund der hohen Feldstärke sämtliche verfügbaren Ladungsträger rekrutiert. Die Lawinenphotodiode zählt somit wie der namensgebende Geigerzähler Einzelereignisse. Lawinenphotodioden im Geiger-Modus werden auch als SPAD (Single-Photon Avalanche Diode) bezeichnet.

Die hohe Empfindlichkeit hat aber auch gravierende Nachteile, denn nicht nur ein einzelnes Nutzlichtphoton, sondern auch ein schwaches Störereignis durch Fremdlicht, optisches Übersprechen oder Dunkelrauschen kann den Lawinendurchbruch auslösen. Dieses Störereignis trägt dann mit dem gleichen relativ starken Signal zum Messergebnis bei wie das empfangene Nutzlicht und ist davon auch aus dem Signal heraus nicht unterscheidbar. Anschließend bleibt die Lawinenphotodiode für eine Totzeit von ca. 10 bis 100ns unempfindlich und fällt solange für weitere Messungen aus. Für eine pulsbasierte Distanzmessung bedeutet dies, dass eine Lawinenphotodiode im Geiger-Modus in einer beträchtlichen Zahl der Fälle anstelle der gesuchten Lichtlaufzeit eine zufällige Zeit eines Störereignisses ausgibt und zudem für das eigentliche Messereignis geblendet ist. Die Distanzbestimmung ist deshalb äußerst unzuverlässig und fremdlichtanfällig. Das gilt ganz entsprechend für eine 3D-Kamera auf Lichtlaufzeitbasis. Hier ist Regel- und nicht Ausnahmefall, dass eine größere Anzahl von Pixeln anstelle des Empfangspulses ein Störereignis registriert, so dass die Tiefenkarte löchrig beziehungsweise mit Störstellen überzogen wird.

Aus der DE 101 46 752 A1 ist eine optoelektronische Vorrichtung zum Erfassen von Objekten bekannt, deren Sendelichtstrahlen von einem Schwingspiegel in zwei Raumrichtungen abgelenkt werden. Dieser Schwingspiegel ist als mikromechanischer Scannerspiegel ausgebildet. Als Empfänger dient eine einfache Photodiode, deren Signale in Abhängigkeit von der Ablenkposition des Schwingspiegels ausgewertet werden. Der Einsatz einer Lawinenphotodiode im Geiger-Modus wird in der DE 101 46 752 A1 nicht diskutiert. Aber selbst wenn man einfach die vorhandene Photodiode gegen eine Lawinenphotodiode im Geiger-Modus austauschen würde, wäre der Sensor wegen der oben geschilderten Problematik bei Fremdereignissen praktisch nicht zu gebrauchen. Außerdem verwendet die DE 101 46 752 A1 ein Phasenverfahren, und wegen ihres praktisch digitalen Reaktionsverhaltens und der auf jede Lawine folgenden Refraktär- oder Totzeit ist eine Lawinenphotodiode im Geiger-Modus zu einer Phasenmessung gar nicht in der Lage.

Es ist daher Aufgabe der Erfindung, die Robustheit einer Messung eines optoelektronischen Sensors mit Lawinenphotodioden im Geigermodus zu verbessern.

Diese Aufgabe wird durch einen optoelektronischen Sensor mit einem Lichtempfänger, der eine Vielzahl von im Geiger-Modus betriebenen Lawinenphotodiodenelementen aufweist, sowie ein Verfahren zur Objekterfassung nach Anspruch 1 beziehungsweise 15 gelöst. Dabei geht die Erfindung von einem Lichtempfänger mit einer Vielzahl von Lawinenphotodioden aus, die im Geiger-Modus betrieben, d.h. immer dann, wenn sie aktiv sind und Licht erfassen sollen, oberhalb ihrer Durchbruchspannung vorgespannt werden. Um nun Fremdereignisse von Messereignissen zu trennen, wird mindestens eine Gruppe von Lawinenphotodioden gebildet. Eine Gruppenauswertungseinheit ist mit der Gruppe verbunden, um die Empfangssignale der Lawinenphotodioden zu empfangen. Diese Verbindung kann beispielsweise darin bestehen, dass die Signale des Lichtempfängers von außen ausgelesen und dort gruppenweise ausgewertet werden, oder dass sich entsprechende Auswertungselektronik direkt auf dem Chip des Lichtempfängers befindet, die Verbindungsleitungen zumindest zu den Lawinenphotodioden der zugehörigen Gruppe aufweist.

Der Grundgedanke der Erfindung ist nun, dass ein Einzelereignis nicht genügt, um eine Messung auszulösen, sondern dazu eine Koinzidenzentscheidung in Form einer Mehrfachdetektion in mehreren Lawinenphotodioden vorzugsweise in örtlicher Nachbarschaft erforderlich ist. Ein Ereignis wird dafür nur dann als Messereignis angesehen, wenn es innerhalb eines Toleranzzeitfensters gleichzeitig in einer Mindestanzahl von Lawinenphotodioden einer Gruppe erfasst wird. Umgekehrt werden demnach gleichzeitige Signale einer kleineren Anzahl von Lawinenphotodioden der Gruppe als Fremdereignis ausgeblendet und somit unterdrückt. Über die Mindestanzahl wird somit eine statistische Schwelle gemäß einer Binomialverteilung definiert, mit der Mess- von Störereignissen getrennt werden.

Die Erfindung hat den Vorteil, dass durch die erforderliche Mehrfachdetektion die Fremdlichtempfindlichkeit deutlich herabgesetzt wird. Der Sensor ist in der Lage, auch unter stark gestörten Bedingungen zu messen. Bei einer Distanzmessung wird mit hoher Zuverlässigkeit sichergestellt, dass die korrekte Distanzinformation des Zielobjektes und kein Störereignis erfasst wird. Die Genauigkeit von Tiefenkarten eines 3D-Sensors und deren Dichte, also die Besetzung der Pixel mit korrekten Distanzwerten, wird erheblich verbessert.

Die Lawinenphotodiodenelemente weisen bevorzugt eine Durchbruchspannung von höchstens 70V, insbesondere von höchstens 50V, 30V oder 15V auf. Eine Hochspannungsversorgung wie bei herkömmlich genutzten Lawinenphotodioden kann damit entfallen, und es werden erheblich geringere Herstellkosten möglich.

Die Lawinenphotodiodenelemente sind vorzugsweise in einem CMOS-Prozess hergestellt, insbesondere als Matrixstruktur auf einem gemeinsamen Substrat. Der Lichtempfänger wird somit kostengünstig verfügbar. Ein CMOS-Bauteil ermöglicht unter anderem kleine Strukturen und somit auch eine im Vergleich zu einer herkömmlichen Lawinenphotodiode deutlich herabgesetzte Durchbruchspannung.

Der Sensor ist bevorzugt ein entfernungsmessender Sensor mit einem Lichtsender zum Aussenden von Lichtpulsen und einer Lichtlaufzeitmesseinheit, um eine Lichtlaufzeit zwischen dem Sendezeitpunkt eines ausgesandten Lichtpulses und einem Empfangszeitpunkt des von einem Lawinenphotodiodenelement aus dem Überwachungsbereich empfangenen Lichtpulses zu messen. Dieser Sensor empfängt also das im Überwachungsbereich reflektierte oder remittierte eigene Sendelicht. Daraus ergibt sich die Erwartung, dass das Toleranzzeitfenster für eine gleichzeitige Detektion in den Lawinenphotodioden einer Gruppe in der Größenordnung der Pulsbreite des gesendeten Lichtpulses liegt. Es gibt verschiedene Wege für eine intelligente Verknüpfung von Lawinenphotodioden, um zu einer Koinzidenzentscheidung über die Lichtlaufzeit zwischen Sendezeitpunkt und dem durch die fast gleichzeitig ausgelösten Lawinen definierten Empfangszeitpunkt zu kommen. Beispielsweise kann für jede Lawinenphotodiode einzeln eine Zeitmessung durchgeführt und in der Gruppenauswertungseinheit geprüft werden, ob sich die erforderliche Mindestanzahl innerhalb einer Gruppe über eine Lichtlaufzeit einig ist. In einem anderen Beispiel werden die einzelnen Empfangssignale der Lawinenphotodioden einer Gruppe mit einem durch das Toleranzzeitintervall vorgegebenen Abklingverhalten aufaddiert. Wenn der entstehende Gesamtpuls eine Schwelle entsprechend der Mindestanzahl überschreitet, wird dessen Lage als Empfangszeitpunkt ausgewertet.

Der Lichtempfänger weist bevorzugt eine Matrix von Lawinenphotodiodenelementen in einer Vielzahl von Gruppen auf. Dabei soll der Begriff Matrix in diesem Zusammenhang sowohl eng als auch weit verstanden werden. Im engeren Sinn ist eine Matrix ein regelmäßiges orthogonales Rechteckraster von pixelartig angeordneten Lawinenphotodioden, die beispielsweise kachelartig zu rechteckigen Gruppen zusammengefasst sind. Ebenso kann eine Matrix aber auch im weiteren Sinn eine beliebige regelmäßige Anordnung bezeichnen. Die Gruppen sind vorzugsweise untereinander identische Teilmuster der regelmäßigen Struktur. Die Zugehörigkeit von Lawinenphotodioden zu Gruppen muss unbedingt nicht eindeutig sein, Gruppen können durch mehreren Gruppen zugewiesene Lawinenphotodioden überschneiden.

Die Lawinenphotodiodenelemente bilden bevorzugt eine hexagonale Wabenstruktur. Dadurch kann eine große Kompaktheit des Lichtempfängers und insbesondere ein hoher Füllfaktor auf einem Chip des Lichtempfängers erreicht werden. Dieser Füllfaktor wird noch weiter optimiert, wenn die Lawinenphotodiodenelemente kreisförmig ausgebildet sind. Diese Anordnung entspricht einer dichtesten Kugelpackung. Es sind aber auch andere Formen denkbar, etwa hexagonale Waben.

Der Lichtempfänger weist bevorzugt auf einem Substrat des Lichtempfängers lokale Auswertungsstrukturen für die Lawinenphotodiodenelemente auf. Diese Auswertungsstrukturen umfassen beispielsweise die Gruppenauswertungseinheit oder die Lichtlaufzeitmesseinheit. Die lokalen Auswertungsstrukturen können mit einer Auswertungseinheit außerhalb des Lichtempfängers ergänzt und somit Teilfunktionen auf lokale und externe Auswertungen verteilt werden. Vorzugsweise beansprucht jede lokale Auswertungsstruktur auf dem Lichtempfänger die gleiche Zellengröße wie eine Lawinenphotodiode und ist dann für die Ansteuerung und Auswertung benachbarter Lawinenphotodioden zuständig, misst also beispielsweise die Lichtlaufzeit für diese Lawinenphotodioden und trifft die Koinzidenzentscheidung, ob ein Ereignis innerhalb des Toleranzzeitfensters in einer Mindestanzahl der Gruppe detektiert wird. Durch die lokale Verarbeitung werden viele Einzeldaten vorgefiltert, so dass nur noch zusammenfassende Messinformationen ausgelesen werden müssen und sich die anfallende Datenmenge ganz erheblich reduziert. Die intrinsische Verstärkung einer Lawinenphotodiode im Geiger-Modus erlaubt dabei eine direkte digitale Implementierung der Auswertungsschaltungen. Andererseits kann eine analoge Addition Gatterfunktionen einsparen und den Füllfaktor auf dem Lichtempfänger erhöhen.

Bevorzugt ist jeweils eine lokale Auswertungsstruktur im Zentrum einer hexagonalen Wabe mit sechs benachbarten Lawinenphotodioden angeordnet. Dabei sitzen demnach sechs Lawinenphotodioden um eine siebte Zelle mit der Auswertungseinheit im Zentrum. Vorzugsweise entspricht eine solche Wabe auch einer Gruppe. Ein möglicher Überlapp der Waben, bei dem also Lawinenphotodioden mehreren benachbarten Zentren mit einer Auswertungsstruktur zugeordnet sind, führt zu einer zusätzlichen Überlagerung der Gruppenverknüpfung, die für die Koinzidenzentscheidung und das Detektionsverhalten insgesamt vorteilhaft sein kann.

Die Mindestanzahl in der Gruppenauswertungseinheit ist bevorzugt parametrierbar oder steuerbar. Damit wird eine Adaption an die Lichtverhältnisse im Betrieb ermöglicht. Werden Mindestanzahlen lokal und sogar dynamisch angepasst, so kann der Sensor hochflexibel auf unterschiedlich helle Bereiche beziehungsweise Phasen reagieren. Beispielsweise wird eine Lichtquelle oder ein Fenster in der Szenerie virtuell durch eine hohe Mindestanzahl abgedunkelt, während ein dunkles Objekt daneben mit einer geringen Mindestanzahl hochempfindlich erfasst wird.

Vorzugsweise ist eine Aktivierungseinheit vorgesehen, die dafür ausgebildet ist, nur Lawinenphotodiodenelemente des Lichtempfängers innerhalb eines erwarteten Empfangslichtflecks zu aktivieren. Durch Fremdereignisse ausgelöste Lawinen können erheblich zur Verlustleistung des Lichtempfängers beitragen. Diese wird begrenzt, indem Fremdereignisse außerhalb des erwarteten Empfangslichtflecks ausgeblendet werden. Praktisch geschieht dies dadurch, dass die Biasspannung nur in den aktiven Lawinenphotodioden oberhalb der Durchbruchspannung liegt und in den übrigen Lawinenphotodioden unterhalb der Durchbruchspannung gesenkt wird. Eine unbegrenzte Lawine mit entsprechender Leistungsaufnahme und einem hohen Signal, das als Messereignis registriert wird, tritt dann nur in den aktiven Lawinenphotodioden auf. Damit wird nicht nur die Verlustleistung herabgesetzt, es fallen zugleich auch wesentlich weniger Daten an, weil Störereignisse außerhalb der aktiven Lawinenphotodioden nicht auftreten oder ignoriert werden und daher nicht zum Datenfluss beitragen.

Die Position des erwarteten Empfangslichtflecks ist bevorzugt in einem Einlernvorgang bestimmt. Dies dient der elektronischen Justierung des Sensors. Statt den Lichtsender und den Lichtempfänger ganz exakt aufeinander auszurichten, genügt es, wenn das Nutzlicht irgendwo auf den Lichtempfänger fällt. Die genaue Position wird elektronisch bestimmt, und nur die Lawinenphotodioden an dieser Position werden anschließend im Betrieb aktiviert.

Der Sensor ist bevorzugt als Scanner ausgebildet und weist eine Ablenkeinheit mit einem MEMS-Spiegel (Mikroelektromechanisches System) auf, um mit einem Sendelichtstrahl eines Lichtsenders den Überwachungsbereich abzutasten. Dadurch wird der Aufbau eines extrem kompakten Sensors ermöglicht, der auch in einem mobilen Kommunikationsgerät Platz findet, beispielsweise einem Notebook oder einem Mobiltelefon. Der MEMS-Spiegel schwingt in Resonanz und tastet daher mit dem Sendelichtstrahl eine Zeile der Szenerie sehr schnell ab. Möchte man anstelle einer Zeile einen rechteckigen Bereich erfassen, wird der schnellen Schwingung eine langsamere Ablenkbewegung des MEMS-Spiegels in einer senkrechten Richtung überlagert.

Anders als bei einem herkömmlichen Scanner wird der Empfangslichtstrahl vorzugsweise nicht über den MEMS-Spiegel für den Sendelichtstrahl geführt. Stattdessen betrachtet der Lichtempfänger in dieser Ausführungsform die gesamte abgetastete Szenerie ohne Umlenkung über einen Spiegel. Dabei besteht die Möglichkeit, die Position des erwarteten Empfangslichtflecks aus der Orientierung der Ablenkeinheit zu bestimmen. Diese Orientierung, die dem momentan von dem Sendelichtstrahl abgetasteten Punkt der Szenerie entspricht, ist beispielsweise aus einem Steuersignal für den MEMS-Spiegel, dessen bekanntem Zeitverhalten oder einem Feedbacksignal des MEMS-Spiegels bekannt. Es werden dann nur Lawinenphotodioden in einem Teilbereich des Lichtempfängers aktiviert, welcher Licht aus dem Bereich der Szenerie empfängt, den der Sendelichtstrahl gerade abtastet.

Dem Lichtempfänger ist bevorzugt eine Empfangsoptik zugeordnet, die den Überwachungsbereich auf den Lichtempfänger abbildet. Das Besondere dieser Empfangsoptik im Gegensatz zu einem herkömmlichen Scanner ist, dass die Empfangsoptik nicht nur den Scanstrahl, sondern die gesamte Szenerie erfasst. Der Empfangslichtstrahl wird dabei in einer bevorzugten Ausführungsform, wie oben beschrieben, auf dem Lichtempfänger verfolgt, der nur dort aktiviert ist, wo Empfangslicht gemäß der Richtung des Sendelichtstrahls erwartet wird.

Die Brennebene der Empfangsoptik stimmt bevorzugt nicht mit einer Ebene des Lichtempfängers überein. Mit anderen Worten ist die Empfangsoptik absichtlich defokussiert, so dass ein Empfangslichtfleck mehrere Lawinenphotodioden, beispielsweise mindestens eine Gruppe von Lawinenphotodioden überstreicht. Im Falle eines Scanners bewirkt dies keinen Auflösungsverlust, weil die Auflösung durch den Sendelichtstrahl und dessen Querschnitt beziehungsweise die Winkelauflösung des Scanners vorgegeben wird. Deshalb kann auch ein aktiver Bereich des Lichtempfängers, in dem der Empfangslichtstrahl erwartet und registriert wird, erheblich größer sein als die resultierende Bildauflösung. Daraus ergeben sich Freiheiten für die Anpassung der Empfindlichkeit durch die Anzahl zu einem Bildpunkt beitragender Lawinenphotodioden sowie die Mindestanzahl für die Erkennung eines Koinzidenzereignisses.

In einer alternativen Ausführungsform ist der Sensor kein Scanner, sondern eine 3D-Kamera. Dabei wird das Sendelicht großflächig in die Szenerie ausgesandt und ortsaufgelöst in den Lawinenphotodioden des Lichtempfängers wieder empfangen. Wird hier die Empfangsoptik defokussiert, so entsteht eine Unschärfe oder ein Auflösungsverlust. Dem steht aber im Vergleich zu einem Lichtempfänger ohne Bilden von Gruppen und Auswerten von Koinzidenzentscheidungen ein erheblicher Gewinn an Robustheit gegenüber. Zudem ist der Auflösungsverlust nicht direkt mit dem Faktor gleichzusetzen, in dem Lawinenphotodioden zu Gruppen zusammengefasst sind. Denn trotz der Defokussierung trägt jede Lawinenphotodiode auch einzeln zu der Bildinformation bei, und dies kann durch geschickte Verknüpfung und Bildauswertung genutzt werden, um den effektiven Auflösungsverlust geringer zu halten.

Eine defokussierte Empfangsoptik ermöglicht zudem die Detektion von "Kantentreffer". Ein solches Ereignis erzeugt auf einer Seite des Fokus' einen Abstandswert einer Seite der Kante. Auf der anderen Seite des Fokus' wird die andere Seite der Kante mit dem entsprechenden Abstandswert abgebildet. Bei Gruppen auf denen sie Kante mit der entsprechenden Unschärfe zu liegen kommt ist die Wahrscheinlichkeit eines Koinzidenzereignisses herabgesetzt. Eine Auswertung dieses Effekts ermöglicht eine Erhöhung der Auflösung.

Vorzugsweise ist eine Metagruppenauswertungseinheit mit mehreren Gruppenauswertungseinheiten verbunden, um nur Ereignisse als Erfassung von Empfangslicht zu werten, die von einer Mindestanzahl der verbundenen Gruppenauswertungseinheiten als Erfassung von Empfangslicht gewertet werden. Es wird also eine nochmals übergeordnete Koinzidenzentscheidung auf der Ebene von Gruppen getroffen. Die Statistik unterscheidet sich dabei nur in dem Maße von einer einstufigen Koinzidententscheidung mit einer gleichen Gesamtzahl beteiligter Lawinenphotodioden, wie bei kleinen Gruppengrößen, Metagruppengrößen und Mindestanzahlen noch Abweichungen der Binomialverteilungen von einer Normalverteilung verbleiben. Eine hierarchische Entscheidung bietet aber Vorteile bei Implementierung und Chipdesign, weil weniger lokale Auswertungselektronik und Verbindungen erforderlich sind. Beispielsweise fällt die Meta-Koinzidenzentscheidung anders als die ursprüngliche Koinzidenzentscheidung nicht lokal auf dem Lichtempfänger, sondern erst außerhalb in einem Mikroprozessor.

Das erfindungsgemäße Verfahren kann auf ähnliche Weise durch weitere Merkmale ausgestaltet werden und zeigt dabei ähnliche Vorteile. Derartige weitere Merkmale sind beispielhaft, aber nicht abschließend, in den sich an die unabhängigen Ansprüche anschließenden Unteransprüchen beschrieben.

Die Erfindung wird nachstehend auch hinsichtlich weiterer Vorteile und Merkmale unter Bezugnahme auf die beigefügte Zeichnung anhand von Ausführungsbeispielen erläutert. Die Figuren der Zeichnung zeigen in:
- Fig. 1: eine Blockdarstellung eines optoelektronischen Sensors in einer Ausführungsform als Scanner mit MEMS-Ablenkspiegel;
- Fig. 2: ein beispielhaftes vereinfachtes Ersatzschaltbild einer Lawinenphotodiode im Geiger-Modus;
- Fig. 3: eine Draufsicht auf eine orthogonale Matrixkonfiguration von Lawinenphotodioden eines Lichtempfängers und deren Zusammenfassung zu Gruppen;
- Fig. 4: eine Draufsicht auf eine hexagonale Konfiguration von Lawinenphotodioden eines Lichtempfängers und deren Zusammenfassung zu Gruppen; und
- Fig. 5: eine Draufsicht auf eine alternative hexagonale Konfiguration von Lawinenphotodioden eines Lichtempfängers und deren Zusammenfassung zu Gruppen.

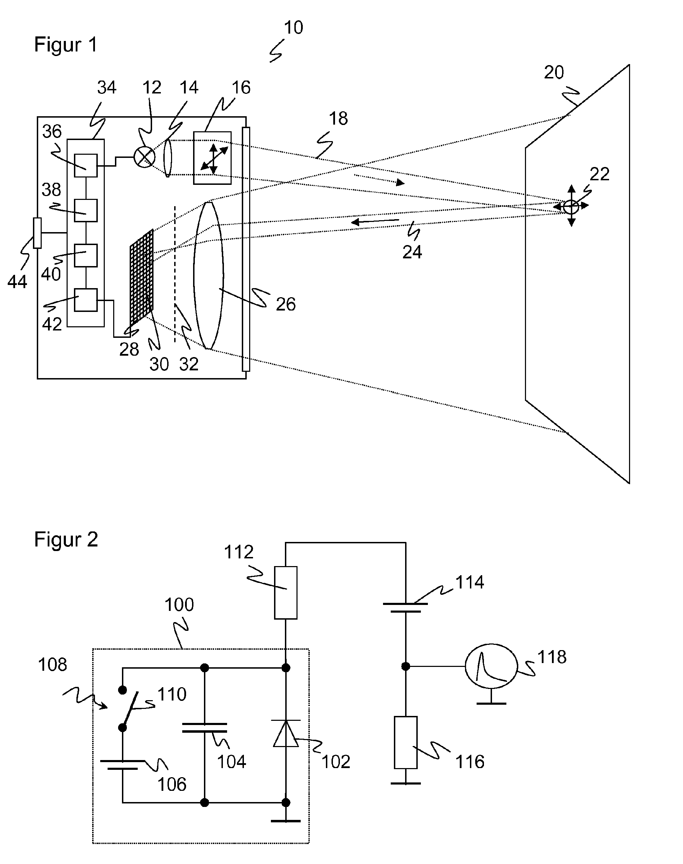

Figur 1 zeigt eine Blockdarstellung eines optoelektronischen Sensors 10, der als kompakter Scanner mit einem MEMS-Spiegel ausgebildet ist. Diese Ausführungsform ist nur beispielhaft zu verstehen. Die Erfindung umfasst auch andere optoelektronische Sensoren, beispielsweise einstrahlige Sensoren und Entfernungstaster oder 3D-Kameras.

Der Sensor 10 weist einen Lichtsender 12 auf, beispielsweise eine Laserdiode, deren Sendelicht in Form kurzer Pulse zunächst in einer Sendeoptik 14 kollimiert und dann von einem MEMS-Ablenkspiegel 16 als Sendestrahl 18 in einen Überwachungsbereich 20 abgelenkt wird. Der MEMS-Ablenkspiegel 16 schwingt auf einer Achse in Resonanz und wird in einer zweiten Achse langsam periodisch verschwenkt. Dadurch scannt ein Abtastlichtfleck 22 zeilenweise den Überwachungsbereich 20 ab. Das an Objekten in dem Überwachungsbereich 20 remittierte Licht wird als Empfangslicht 24 über eine Empfangsoptik 26 auf einen Lichtempfänger 28 mit einer Vielzahl von in Pixeln angeordneter Lichtempfangselemente 30 in Form von Lawinenphotodioden geleitet.

Wie durch eine gestrichelte Linie 32 dargestellt, stimmt die Brennebene der Empfangsoptik 26 nicht mit der Ebene des Lichtempfängers 28 überein. Die Empfangsoptik 26 ist also gezielt defokussiert, so dass das Empfangslicht 24 nicht scharf auf möglichst wenige Lichtempfangselemente 30, sondern aufgeweitet auf eine Gruppe der Lichtempfangselemente 30 abgebildet wird

In dem Sensor 10 ist weiterhin eine Steuer- und Auswertungseinheit 34 vorgesehen, die mit dem Lichtsender 12, dem MEMS-Ablenkspiegel 16 und dem Lichtempfänger 28 verbunden ist. Die Steuer- und Auswerteeinheit 34 umfasst eine Gruppenauswertungseinheit 36, eine Lichtlaufzeitmesseinheit 38, eine Aktivierungseinheit 40 und eine Bildauswertungseinheit 42. Über einen Ausgang 44 kann die Auswertungseinheit 34 Bilddaten und andere Sensormessdaten ausgeben beziehungsweise umgekehrt Steuer- und Parametrieranweisungen entgegennehmen.

Die Lichtempfangselemente 30 des Lichtempfängers 32 sind Lawinenphotodioden, die zur Erfassung von Empfangslicht 24 im Geiger-Modus betrieben werden. Zur Erläuterung zeigt Figur 2 ein beispielhaftes vereinfachtes Ersatzschaltbild einer Lawinenphotodiode. In der Praxis handelt es sich um ein Halbleiterbauteil, dessen nicht dargestellter Aufbau hier als bekannt vorausgesetzt wird. Die Lawinenphotodiode 100 zeigt zum einen das Verhalten einer Diode 102. Sie hat eine Kapazität, die durch einen parallel geschalteten Kondensator 104 repräsentiert wird. Der mögliche Lawinendurchbruch erzeugt Ladungsträger, deren Ursprung in dem Ersatzschaltbild als Stromquelle 106 dargestellt wird. Der Lawinendurchbruch wird durch ein auftreffendes Photon 108 ausgelöst, wobei dieser Vorgang wie ein Schalter 110 wirkt. Nach außen ist die Lawinenphotodiode über einen Widerstand 112 mit einer Stromquelle 114 verbunden. Zwischen dieser Stromquelle und einem weiteren Widerstand 116 kann an einem Punkt 118 das Ausgangssignal betrachtet werden.

Im Bereitschaftszustand liegt über der Diode 102 eine Spannung oberhalb der Durchbruchspannung an. Erzeugt dann ein einfallendes Photon 108 ein Ladungsträgerpaar, so schließt dies gleichsam den Schalter 110, so dass die Lawinenphotodiode über die Stromquelle 106 mit Ladungsträgern geflutet wird. Neue Ladungsträger entstehen aber nur, solange das elektrische Feld stark genug bleibt. Wird durch die Stromquelle 106 der Kondensator 104 so weit entladen, dass die Durchbruchspannung unterschritten ist, so kommt die Lawine von selbst zum Erliegen ("passive quenching"). Danach wird der Kondensator 104 von der äußeren Stromquelle 114 über den Widerstand 112 wieder aufgeladen, bis wieder eine Spannung über der Durchbruchspannung an der Diode 102 anliegt. Es gibt alternative Ausgestaltungen, in denen die Lawine von außen erkannt und daraufhin eine Entladung unter die Durchbruchspannung ausgelöst wird ("active quenching").

Während der Lawine steigt das Ausgangssignal am Punkt 118 rapide und unabhängig von der Intensität des auslösenden Lichts, hier eines Photons 108, auf einen Maximalwert an und fällt dann nach dem Löschen der Lawine wieder ab. Die Pulsform ist am Punkt 118 angedeutet. Die Zeitkonstante des Abfalls, welche eine Totzeit der Lawinenphotodiode 100 angibt, bestimmt sich aus der Kapazität des Kondensators 104 und dem Widerstand 112 und liegt typischerweise im Bereich einiger bis einiger zehn Nanosekunden. Die Totzeit ist keine absolute Totzeit, denn sobald die Vorspannung groß genug ist, um eine Lawine zu unterstützen, kann das Ausgangssignal auch wieder ansteigen, allerdings nicht im gleichen Maße wie aus dem Bereitschaftszustand. Der Verstärkungsfaktor liegt typischerweise in einer Größenordnung von 10^5 bis 10^7 und ergibt sich im Wesentlichen aus der maximalen Anzahl von Ladungsträgern, die von der Lawine in der Lawinenphotodiode 100 rekrutiert werden können.

Fällt das zu messende Ereignis in die Totzeit, so ist die Lawinenphotodiode 100 weitgehend blind. Die Lawinenphotodiode 100 reagiert auch auf jedes Einzelereignis mit dem gleichen Signal, das Abwarten einer ausreichenden Totzeit und Auslösen eines Ladungsträgerpaares vorausgesetzt. Allein ist eine Lawinenphotodiode 100 deshalb weitgehend ungeeignet, um eine Empfangsintensität zu bewerten. Außerdem kann ein einzelnes Photon des Umgebungslichts oder ein einziges Ladungsträgerpaar aufgrund von Dunkelrauschen genügen, um eine Lawine auszulösen, die nichts mit dem zu messenden Ereignis zu tun hat.

Auf dem Lichtempfänger 28 ist eine Vielzahl von einzelnen Lawinenphotodiodenelementen 100 vorgesehen. Ein entsprechendes Bauelement kann beispielsweise in einem CMOS-Prozess hergestellt werden. Die Durchbruchspannung der Lawinenphotodiodenelemente 100 ist deutlich geringer als bei herkömmlichen Lawinenphotodioden und beträgt beispielsweise höchstens 70V oder sogar nur 15V-30V.

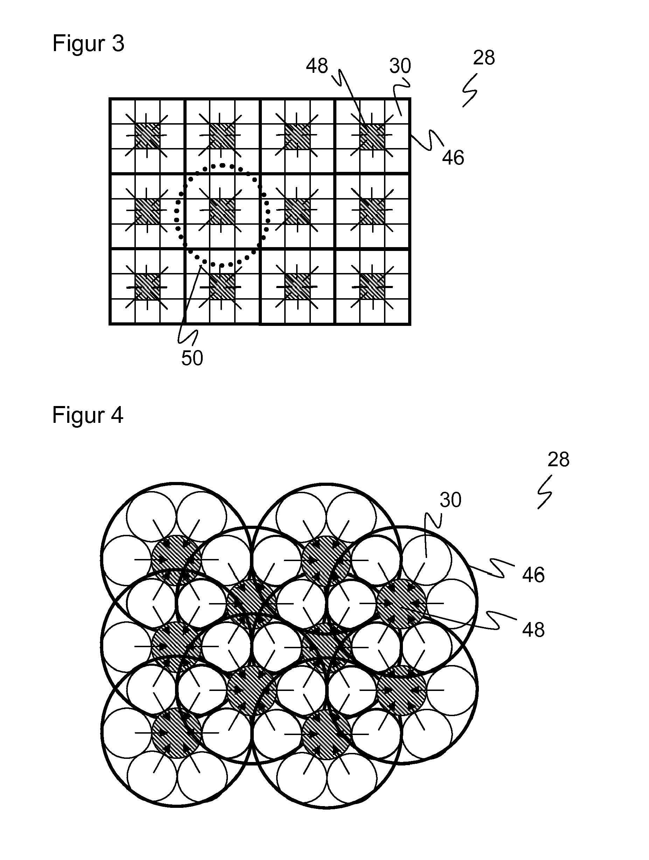

Figur 3 zeigt eine schematische Draufsicht auf eine Anordnung von Lichtempfangselementen 30 des Lichtempfängers 28 in Form von Lawinenphotodioden 100 in einer orthogonalen Matrixstruktur. Auf dem Lichtempfänger 28 sind Lichtempfangselemente 30 kachelartig zu Gruppen 46 zusammengefasst. Im Zentrum jeder Gruppe wird die Halbleiterstruktur des Lichtempfängers 28 statt für die Ausbildung einer Lawinenphotodiode 100 für Auswertungsschaltungen 48 genutzt. Diese Auswertungsschaltungen 48 können insbesondere Aufgaben anstelle der zentralen Gruppenauswertungseinheit 36 und der zentralen Lichtlaufzeitmesseinheit 38 übernehmen oder als Teilimplementierung mit der jeweiligen Funktion in der zentralen Auswertungseinheit 34 zusammenwirken.

Für die Aufnahme einer Tiefenkarte wird nun der Lichtsender 12 mit kurzen Lichtpulsen betrieben, die mit Hilfe des MEMS-Ablenkspiegels 16 den Überwachungsbereich 20 zeilenweise abtasten. Wegen der defokussierten Empfangsoptik 26, oder auch aufgrund des intrinsischen Querschnitts des Sendelichtstrahls 18 bei fokussierter Empfangsoptik, fällt der Empfangslichtfleck 50 auf mehrere Lichtempfangselemente 30. In Abhängigkeit einer Vielzahl von Faktoren, wie Entfernung zum angetasteten Objekt, dessen Remission, Leistung des Lichtpulses oder Fläche der Lichtempfangselemente 30, werden in einigen der Lawinenphotodioden 100 innerhalb des Empfangslichtflecks 50 die einer ungebremsten Lawine entsprechenden Signale ausgelöst. Zugleich geschieht dies auch in einer Anzahl von Lawinenphotodioden 100 innerhalb und außerhalb des Empfangslichtflecks 50 aufgrund von Ereignissen, die mit der Messung in keinem Zusammenhang stehen, etwa Fremdlicht oder Dunkelrauschen.

Um solche zufälligen Ereignisse auszublenden, wird in der Gruppenauswertungseinheit 36 eine Koinzidenzentscheidung getroffen, die verlangt, dass von den n Lichtempfangselementen 30 einer Gruppe 46 eine Mindestanzahl von *k* Lichtempfangselementen 30 ein Messereignis innerhalb einer zeitlichen Toleranz gleichzeitig auslösen. Die Feststellung eines Messereignisses wird somit von einer Einzelentscheidung eines Lichtempfangselements 30 auf eine binomialverteilte statistische Koinzidenzentscheidung der Gruppe 46 verlagert. Diese ist wesentlich robuster gegenüber Zufallsereignissen und überdies durch Anpassung der Größe n einer Gruppe 46 und die geforderte Mindestanzahl *k* an verschiedene Umgebungsbedingungen anpassbar. Eine solche Anpassung kann sogar lokal und dynamisch erfolgen, um unabhängig von örtlichen und zeitlichen Umgebungslichtverteilungen zuverlässige Messdaten sowohl aus hellen wie dunklen Teilbereichen des Überwachungsbereichs 20 zu erhalten.

Die Lichtlaufzeitmesseinheit 38 bestimmt die Lichtlaufzeit zwischen Aussenden eines Lichtpulses und dessen Registrieren in dem Lichtempfänger 30, um daraus über die konstante Lichtgeschwindigkeit eine Distanz zu dem angetasteten Objektabschnitt des Überwachungsbereichs 20 zu berechnen. Im Verlauf der Abtastung durch den MEMS-Ablenkspiegel 16 entsteht dann eine Tiefenkarte des Überwachungsbereichs 20. Die Koinzidenzentscheidung verlangt, dass sich *k* der *n* Lichtempfangselemente 30 über den Empfangszeitpunkt einig sind, welcher der Lichtlaufzeitberechnung zugrunde gelegt wird.

Der MEMS-Ablenkspiegel 16 steht mit der Auswertungseinheit 34 und speziell der Aktivierungseinheit 40 in Verbindung, so dass die aktuelle Orientierung des MEMS-Ablenkspiegels, damit die Richtung des Sendelichtstrahls 18 und die erwartete Position des Empfangslichtflecks 50 auf dem Lichtempfänger 28 bekannt ist. Die Aktivierungseinheit 40 ist damit in der Lage, diejenigen Lichtempfangselemente 30 zu deaktivieren, die ohnehin nicht so positioniert sind, dass sie Nutzlicht empfangen könnten. Dafür werden nur die Lichtempfangselemente 30 innerhalb der erwarteten Position des Empfangslichtflecks 50 aktiviert, d.h. oberhalb der Durchbruchspannung vorgespannt. Die erwartete Position des Empfangslichtflecks 50 und damit der Bereich aktiver Lichtempfangselemente 30 vollzieht also auf dem Lichtempfänger 18 eine der Abtastung des Überwachungsbereich 20 durch den Abtastlichtfleck 22 entsprechende Bewegung. Dabei kann jeweils der Bereich um die erwartete Position des Lichtflecks 50 wie in Figur 3 in etwa einer Gruppe 46 entsprechen. Dies ist aber nicht zwingend, denn auch weitere benachbarte Lichtempfangselemente 30 können zu einer sinnvollen Messung beitragen. Die Auflösung wird ohnehin nicht empfangs- sondern sendeseitig durch Parameter wie den Querschnitt des Sendelichtstrahls 18, die Pulslänge der Sendelichtpulse sowie deren Wiederholfrequenz oder die Winkelauflösung des MEMS-Ablenkspiegels 16 festgelegt. Der tatsächliche Empfangslichtfleck hängt zusätzlich von der Defokussierung der Empfangsoptik 26 ab, die deshalb passend eingestellt sein sollte.

Die so entstandene Tiefenkarte kann anschließend noch durch Bildverarbeitung in der Bildverarbeitungseinheit 42 verbessert werden, etwa durch Bearbeitung mit Glättungsfiltern, eine Plausibilisierung oder Ergänzung durch Vergleich mit früheren Bildern (Szenenauswertung, Objekterkennung, Objekttracking), eine Kanten- oder Flächenvervollständigung (Region Growing) und dergleichen.

Figur 4 zeigt eine alternative Anordnung der Lichtempfangselemente 30, der Gruppen 46 und der Auswertungsschaltungen 48 auf dem Lichtempfänger 28. Dabei sind die Lichtempfangselemente 30 kreisförmig ausgebildet und bilden eine hexagonale Wabenstruktur. Die sieben Zellen einer Wabe sind jeweils in einer Gruppe 46 zusammengefasst, wobei die Zelle in deren Zentrum nicht für ein Lichtempfangselement 30, sondern für Auswertungsschaltungen 48 genutzt wird. Mit der Anordnung gemäß Figur 4 wird ein hoher Füllfaktor erzielt. In dem dargestellten Beispiel sind Lichtempfangselemente 30 nicht eindeutig einer Gruppe 46 zugeordnet, sondern allen benachbarten Gruppen 46. Das kann vorteilhaft sein, damit Messereignisse zu mehreren Gruppen 46 beitragen. Alternativ könnten aber Gruppen 46 auch überlappungsfrei gebildet werden

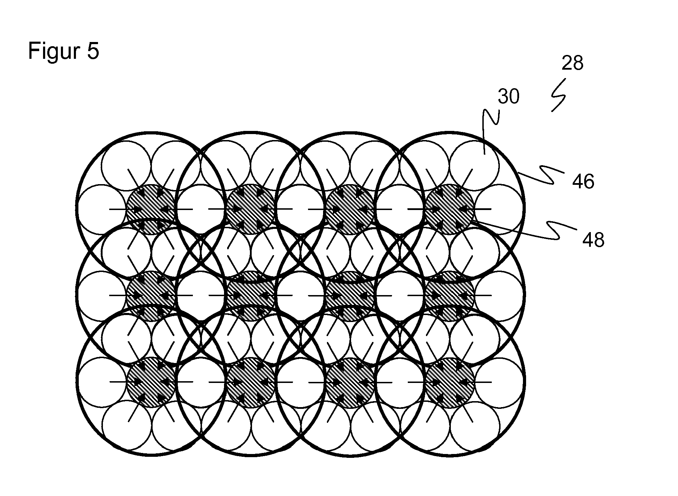

Figur 5 zeigt eine weitere Anordnung der Lichtempfangselemente 30, der Gruppen 46 und der Auswertungsschaltungen 48 auf dem Lichtempfänger mit einer hexagonalen Wabenstruktur. Im Unterschied zu Figur 4 liegen hierbei die Auswertungsschaltungen 48 auf einer orthogonalen Matrix. Eine solche regelmäßige Anordnung kann Vorteile beispielsweise hinsichtlicht der Verschaltung haben. Außerdem wird der Überlapp variiert, also die Zugehörigkeit der Lichtempfangselemente 30 zu einer Gruppe 46. Es sind weitere Variationen der Anordnung in einer wabenartigen Struktur wie in den Figuren 4 und 5 oder in anderen Strukturen denkbar.

Die Erfindung wird anhand eines MEMS-Scanners beschrieben, der in zwei Richtungen beweglich ist. Alternativ ist ein Scanner mit nur einer Scanrichtung denkbar, bei dem beispielsweise das zusätzliche Verschwenken neben der Schwingung in Resonanz entfällt. Der zeilenförmige Erfassungsbereich kann für bestimmte Anwendungen ausreichen. Außerdem ist denkbar, den Lichtempfänger 28 dennoch mit mehreren Zeilen von Lichtempfangselementen 30 auszubilden. Die redundanten Lichtempfangselemente in Spaltenrichtung können dann genutzt werden, um auch für kleine Abmessungen in Zeilenrichtung größere Gruppen zu bilden.

Lawinenphotodioden im Geiger-Modus kennen praktisch nur die eine einheitliche Intensität einer ungebremsten Lawine. Somit sind sie zunächst zum Messen von Intensitäten, also Amplituden- oder Helligkeitsinformationen, nicht geeignet. Durch das Bilden von Gruppen 46 kann aber eine solche Helligkeitsinformation doch wieder zurückgewonnen werden, indem analog zu der Koinzidenzentscheidung die Anzahl in einer Messung ansprechender Lichtempfangselemente 30 statistisch ausgewertet wird.

## Patentansprüche

1. Optoelektronischer Sensor (10) mit einem Lichtempfänger (28), der eine Vielzahl von Lawinenphotodiodenelementen (30) zur Erfassung von Empfangslicht (24) aus einem Überwachungsbereich (20) aufweist, die jeweils mit einer Vorspannung oberhalb einer Durchbruchspannung vorgespannt und somit in einem Geiger-Modus betrieben sind,
**gekennzeichnet durch**
mindestens eine Gruppenauswertungseinheit (36), die mit einer Gruppe (46) der Lawinenphotodiodenelemente (30) verbunden ist, um deren Empfangssignal zu empfangen, und die dafür ausgebildet ist, nur Ereignisse als Erfassung von Empfangslicht (24) zu werten, bei denen eine Mindestanzahl von Lawinenphotodiodenelementen (30) der Gruppe (46) innerhalb eines Toleranzzeitintervalls gleichzeitig ein Empfangssignal erzeugt.

2. Sensor (10) nach Anspruch 1,
wobei die Lawinenphotodiodenelemente (30) eine Durchbruchspannung von höchstens 70V, insbesondere von höchstens 50V, 30V oder 15V aufweisen und/oder wobei die Lawinenphotodiodenelemente (30) in einem CMOS-Prozess hergestellt sind, insbesondere als Matrixstruktur auf einem gemeinsamen Substrat.

3. Sensor (10) nach Anspruch 1 oder 2,
der ein entfernungsmessender Sensor mit einem Lichtsender (12) zum Aussenden von Lichtpulsen (18) und einer Lichtlaufzeitmesseinheit ist, um eine Lichtlaufzeit zwischen dem Sendezeitpunkt eines ausgesandten Lichtpulses (18) und einem Empfangszeitpunkt des von einem Lawinenphotodiodenelement (30) aus dem Überwachungsbereich (20) empfangenen Lichtpulses (24) zu messen.

4. Sensor (10) nach einem der vorhergehenden Ansprüche,
wobei der Lichtempfänger (28) eine Matrix von Lawinenphotodiodenelementen (30) in einer Vielzahl von Gruppen (46) aufweist.

5. Sensor (10) nach einem der vorhergehenden Ansprüche,
wobei die Lawinenphotodiodenelemente (30) eine hexagonale Wabenstruktur bilden und insbesondere kreisförmig ausgebildet sind.

6. Sensor (10) nach einem der vorhergehenden Ansprüche,
wobei der Lichtempfänger (28) auf einem Substrat des Lichtempfängers (28) lokale Auswertungsstrukturen (48) für die Lawinenphotodiodenelemente (30) aufweist.

7. Sensor (10) nach Anspruch 5 und 6,
wobei jeweils eine lokale Auswertungsstruktur (48) im Zentrum einer hexagonalen Wabe mit sechs benachbarten Lawinenphotodioden (30) angeordnet ist

8. Sensor (10) nach einem der vorhergehenden Ansprüche,
wobei die Mindestanzahl in der Gruppenauswertungseinheit (36) insbesondere lokal parametrierbar oder steuerbar ist.

9. Sensor (10) nach einem der vorhergehenden Ansprüche,
wobei eine Aktivierungseinheit (40) vorgesehen ist, die dafür ausgebildet ist, nur Lawinenphotodiodenelemente (30) des Lichtempfängers (28) innerhalb eines erwarteten Empfangslichtflecks (50) zu aktivieren.

10. Sensor (10) nach Anspruch 9,
wobei die Position des erwarteten Empfangslichtflecks (50) in einem Einlernvorgang bestimmt ist.

11. Sensor (10) nach einem der vorhergehenden Ansprüche,
der als Scanner ausgebildet ist und eine Ablenkeinheit (16) mit einem MEMS-Spiegel aufweist, um mit einem Sendelichtstrahl (18) eines Lichtsenders (12) den Überwachungsbereich (20) abzutasten, wobei insbesondere die Position des erwarteten Empfangslichtflecks (50) aus der Orientierung der Ablenkeinheit (16) bestimmt ist.

12. Sensor (10) nach einem der vorhergehenden Ansprüche,
wobei dem Lichtempfänger (28) eine Empfangsoptik (26) zugeordnet ist, die den Überwachungsbereich (20) auf den Lichtempfänger (28) abbildet.

13. Sensor (10) nach Anspruch 12,
wobei die Brennebene (32) der Empfangsoptik (26) nicht mit einer Ebene des Lichtempfängers (28) übereinstimmt.

14. Sensor (10) nach einem der vorhergehenden Ansprüche,
wobei eine Metagruppenauswertungseinheit (32) mit mehreren Gruppenauswertungseinheiten (36, 48) verbunden ist, um nur Ereignisse als Erfassung von Empfangslicht (24) zu werten, die von einer Mindestanzahl der verbundenen Gruppenauswertungseinheiten (36, 48) als Erfassung von Empfangslicht (24) gewertet werden.

15. Verfahren zur Objekterfassung in einem Überwachungsbereich (20) mit einem Lichtempfänger (28), der eine Vielzahl von Lawinenphotodiodenelementen (30) aufweist, die jeweils mit einer Vorspannung oberhalb einer Durchbruchspannung vorgespannt und somit in einem Geiger-Modus betrieben werden, **dadurch gekennzeichnet,**
**dass** die Empfangssignale einer Gruppe (46) von Lawinenphotodiodenelementen (30) gemeinsam ausgewertet werden und nur Ereignisse als Erfassung von Empfangslicht (24) gewertet werden, bei denen eine Mindestanzahl von Lawinenphotodiodenelementen (30) der Gruppe (46) innerhalb eines Toleranzzeitintervalls gleichzeitig ein Empfangssignal erzeugt.
